(19) Europäisches Patentamt
European Patent Office
Office européen des brevets

(11) Veröffentlichungsnummer: **0 184 725**
**B1**

(12) # EUROPÄISCHE PATENTSCHRIFT

(45) Veröffentlichungstag der Patentschrift: **04.01.89**

(51) Int. Cl.[4]: **G 03 F 7/02,** G 03 C 1/68

(21) Anmeldenummer: **85115125.8**

(22) Anmeldetag: **28.11.85**

(54) **Lichtempfindliches Gemisch.**

(30) Priorität: **06.12.84 US 678912**

(43) Veröffentlichungstag der Anmeldung: **18.06.86 Patentblatt 86/25**

(45) Bekanntmachung des Hinweises auf die Patenterteilung: **04.01.89 Patentblatt 89/1**

(84) Benannte Vertragsstaaten: **DE FR GB NL**

(56) Entgegenhaltungen:
**DE-A-2 903 270**
**DE-A-2 917 483**
**FR-A-2 153 468**
**FR-A-2 450 473**
**US-A-4 316 949**

(73) Patentinhaber: **HOECHST CELANESE CORPORATION, Route 202- 206 North, Somerville, N.J. 08876 (US)**

(72) Erfinder: **Walls, John E., 19 Bowlby Street, Hampton, N.J. 08801 (US)**
Erfinder: **Tellechea, Carlos, 82 East End Avenue, Shrewsbury New Jersey 07701 (US)**

(74) Vertreter: **Euler, Kurt Emil, Dr., HOECHST AG - Werk KALLE Patentabteilung Postfach 3540 Rheingaustrasse 190, D-6200 Wiesbaden (DE)**

**EP 0 184 725 B1**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

LIBER, STOCKHOLM 1989

**Beschreibung**

Die Erfindung betrifft ein lichtempfindliches Gemisch, das zur Herstellung verbesserter lichtempfindlicher Materialien, insbesondere von Flachdruckplatten, geeignet ist. Die erfindungsgemäßen Druckplatten zeichnen sich durch eine höhere Druckauflage aus.

Die meisten bekannten negativ arbeitenden Flachdruckplatten bestehen aus einem Metallträger, der mit einem Gemisch aus einem Polykondensationsprodukt einer lichtempfindlichen Diazoniumverbindung und geeigneten harzartigen Bindemitteln, Farbmitteln, Stabilisatoren, Belichtungsindikatoren, Netzmitteln usw., beschichtet ist.

Aus den DE-A-2 361 931, 2 903 270 und 3 007 212 sind Kombinationen derartiger Gemische mit polymerisierbaren Verbindungen und Photoinitiatoren bekannt, die sich durch eine höhere Auflösung gegenüber reinen photopolymerisierbaren Schichten und eine höhere Druckauflage gegenüber Schichten auszeichnen, die allein Diazoverbindungen als lichtempfindliche Substanzen enthalten. Im Zuge steigender Anforderungen wäre jedoch eine weitere Erhöhung der Druckauflage wünschenswert.

Aufgabe der Erfindung war es, ein lichtempfindliches Gemisch vorzuschlagen, das zur Herstellung von Flachdruckplatten mit weiter erhöhter Auflage geeignet ist.

Erfindungsgemäß wird ein lichtempfindliches Gemisch, das für die Herstellung von Flachdruckplatten geeignet ist, vorgeschlagen, das als wesentliche Bestandteile

a) ein polymeres Bindemittel,
b) ein Diazoniumsalz-Polykondensationsprodukt,
c1) einen radikalisch polymerisierbaren niedermolekularen Acryl- oder Methacrylsäureester mit 3 bis 6 ungesättigten Gruppen,
c2) einen radikalisch polymerisierbaren, Urethangruppen enthaltenden oligomeren Acryl- oder Methacrylsäureester und
d) einen Initiator für die Photopolymerisation

enthält.

Das erfindungsgemäße Gemisch ist dadurch gekennzeichnet, daß der oligomere Acryl- oder Methacrylsäureester (c2) durch Umsetzen eines im wesentlichen linearen oligomeren Diols mit 2 mol eines Diisocyanats und weiteres Umsetzen des erhaltenen oligomeren Diisocyanats mit 2 mol eines Hydroxyalkylesters der Acryl- oder Methacrylsäure erhalten worden ist.

Die für die erfindungsgemäßen Gemische geeigneten Bindemittel sind vorzugsweise Polymere, die bei Bestrahlung mit aktinischem Licht nicht mit sich selbst oder anderen Verbindungen reagieren. Sie sollten im wesentlichen in organischen Lösemitteln löslich und bevorzugt nicht überwiegend alkali-, säure- oder wasserlöslich sein. Das Molekulargewicht des Bindemittels muß einerseits so hoch sein, daß eine zähe Schicht mit klebfreier Oberfläche erhalten wird, die bei Verwendung als Flachdruckplatte eine große Anzahl qualitativ einwandfreier Drucke liefert. Andererseits darf das Molekulargewicht des Bindemittels aber auch nicht so hoch sein, daß seine Löslichkeit im lichtempfindlichen Gemisch und bei der Entwicklung beeinträchtigt wird. Das Molekulargewicht des Bindemittels sollte höher als etwa 20 000, bevorzugt höher als etwa 30 000, und insbesondere höher als etwa 40 000 sein.

Als Beispiele für erfindungsgemäß geeignete Bindemittel seien Epoxyharze, Polyvinylacetat, Polyvinylacetale, Polyester, Polyamide, Polyether, Polyurethane und Polyacrylharze, die Homo- oder Copolymeren von Acryl- oder Methacrylsäureestern und/oder von Acryl- oder von Acryl- oder Methacrylsäure sind, genannt. Bevorzugt wird als Bindemittel ein Polymeres aus Vinylacetat-, Vinylalkohol- und Vinylformaleinheiten verwendet, z. B. eines, das unter der Bezeichnung Formvar 12/85 von Monsanto, St. Louis, Missouri, USA, vertrieben wird.

Der Gehalt des Gemischs an polymerem Bindemittel beträgt im allgemeinen etwa 20 bis 75 Gew.-%, bevorzugt etwa 30 bis 65 Gew.-%, insbesondere etwa 35 bis 50 Gew.-%, jeweils bezogen auf den Gesamtgehalt an nichtflüchtigen Bestandteilen.

Als Photoinitiatoren eignen sich besonders radikalische Photoinitiatoren, deren Absorptionsbereich bei etwa 320 bis 400 nm liegt. Dazu gehören zum Beispiel Acetophenone, Benzophenone, Triazine, Benzoine, Benzoinether, Xanthone, Thioxanthone, Acridine und Benzochinone. Bevorzugt werden aromatisch substituierte Bis-trichlormethyl-triazine, wie sie in den DE-A-2 243 621 und 2 718 259 und insbesondere in der EP-A-137 452 beschrieben sind. 2-(4-Styryl-phenyl)-4,6-bis-trichlormethyl-s-triazin ist ein besonders bevorzugter Photoinitiator.

Der Gehalt des erfindungsgemäßen Gemischs an Photoinitiator beträgt bevorzugt etwa 1,5 bis 8,0 Gew.-%, besonders bevorzugt etwa 2,0 bis 6,0 Gew.-%, und insbesondere etwa 3,0 bis 4,0 Gew.-%, jeweils bezogen auf den Gesamtgehalt an nichtflüchtigen Bestandteilen.

Als Diazoniumsalz kann erfindungsgemäß jede der bekannten geeigneten polymeren Diazoniumverbindungen eingesetzt werden. Zu den geeigneten Diazoniumverbindungen gehören die Formaldehydkondensate, wie sie beispielsweise in den US-A-2 063 631 und 2 667 415 beschrieben sind und die Mischkondensationsprodukte, wie sie beispielsweise in den US-A-3 849 392, 3 867 147 und 4 436 804 beschrieben sind.

Die bevorzugten Diazoniumsalz-Polykondensationsprodukte enthalten wiederkehrende Einheiten $A-N_2X$ und B, die

durch zweibindige, von einer kondensationsfähigen Carbonylverbindung abgeleitete Zwischenglieder verbunden sind, wobei die Einheiten $A-N_2X$ sich aus Verbindungen der allgemeinen Formel

$$(R^1-R^3-)_pR^2-N_2X$$

ableiten und wobei

X das Anion der Diazoniumverbindung,
p eine ganze Zahl von 1 bis 3,
$R^1$ einen carbocyclischen oder heterocyclischen aromatischen Rest mit mindestens einer kondensationsfähigen Position,
$R^2$ eine Arylengruppe der Benzol- oder Naphthalinreihe,
$R^3$ eine Einfachbindung oder eine der Gruppen:

$-(CH_2)_q-NR^4-$

$-O-(CH_2)_r-NR^4-$,

$-S-(CH_2)_r-NR^4-$,

$-S-CH_2-CO-NR^4-$,

$-O-R^5-O-$,

-O-,

-S- oder

$-CO-NR^4-$

bedeuten, worin

q eine Zahl von 0 bis 5,
r eine Zahl von 2 bis 5,
$R^4$ Wasserstoff, eine Alkylgruppe mit 1 bis 5 C-Atomen, eine Aralkylgruppe mit 7 bis 12 C-Atomen oder eine Arylgruppe mit 6 bis 12 C-Atomen, und
$R^5$ eine Arylengruppe mit 6 bis 12 C-Atomen ist, und
B den von Diazoniumgruppen freien Rest eines aromatischen Amins, Phenols, Thiophenols, Phenolethers, aromatischen Thioethers, aromatischen Kohlenwasserstoffs, einer aromatischen heterocyclischen Verbindung oder eines organischen Säureamids bedeuten.

Ein besonders bevorzugtes Diazoniumsalz ist das Polykondensationsprodukt aus 3-Methoxy-diphenylamin-4-diazoniumsulfat und 4,4'-Bismethoxymethyldiphenylether im Molverhältnis 1 : 1, ausgefällt als Mesitylensulfonat.

Der Gehalt des erfindungsgemäßen Gemischs an Diazoniumsalz beträgt bevorzugt etwa 3 bis 20 Gew.-%, besonders bevorzugt etwa 5 bis 18 Gew.-% und insbesondere etwa 10 bis 15 Gew.-%, jeweils bezogen auf den Gesamtgehalt an nichtflüchtigen Bestandteilen.

Das erfindungsgemäße photopolymerisierbare Gemisch enthält außerdem einen monomeren Acryl- oder Methacrylsäureester mit drei bis sechs ungesättigten Resten und ein Urethangruppen enthaltendes Oligomeres, das nachstehend genauer beschrieben wird.

Bei dem Monomeren handelt es sich um einen Acryl- oder Methacrylsäureester, der bei bildmäßiger Bestrahlung zur Reaktion mit dem Urethanoligomeren befähigt ist. Bevorzugte Monomere sind flüssige oder feste Verbindungen, deren Viskosität bei 25° C höher als 700 mPa·s, bevorzugt höher als 2000 mPa·s und insbesondere höher als 4000 mPa·s ist.

Verbindungen, die erfindungsgemäß geeignete Monomere darstellen, sind beispielsweise Trimethylolpropantriacrylat und dessen ethoxylierte oder propoxylierte Homologen, Trimethylolpropantrimethacrylat und dessen ethoxylierte oder propoxylierte Homologen, Pentaerythrittriacrylat und -trimethacrylat, Dipentaerythritpentaacrylat und -pentamethacrylat, Dipentaerythrithexaacrylat und -hexamethacrylat, sowie Pentaerythrittetraacrylat und -tetramethacrylat. Bevorzugt wird das Dipentaerythritpentaacrylat; es kann mit Vorteil auch eine Kombination geeigneter Monomerer eingesetzt werden.

Der Anteil des Gemischs an Monomeren beträgt bevorzugt etwa 10 bis 35 Gew.-%, besonders bevorzugt etwa 15 bis 30 Gew.-%, und insbesondere etwa 15 bis 25 Gew.-%, jeweils bezogen auf den Gehalt an nichtflüchtigen Bestandteilen.

Als oligomere Bestandteile des erfindungsgemäßen photopolymerisierbaren Gemischs werden Oligomere mit einer Hauptkette bevorzugt, die aus einer aliphatischen Dicarbonsäure und einem aliphatischen Diol erhalten wurde. Bevorzugt werden lineare Dicarbonsäuren mit 2 bis 8 C-Atomen eingesetzt. Die Herstellung des Polyesters erfolgt so, daß die erhaltene Verbindung endständige Hydroxygruppen aufweist. Geeignete Verfahren sind dem Fachmann bekannt und beispielsweise in Sandler und Karo, Polymer Synthesis, Vol. 2, Academic Press 1977, S. 140-167, beschrieben. Das Polyesterdiol wird dann mit einem vorzugsweise aliphatischen, insbesondere cycloaliphatischen Diisocyanat mit 2 bis 13 C-Atomen, so umgesetzt, daß eine der beiden Isocyanatgruppen mit der endständigen Hydroxygruppe am Ende der Polyesterkette reagiert. Die andere Isocyanatgruppe wird anschließend mit einem Hydroxygruppen enthaltenden Acrylat oder Methacrylat umgesetzt. Beispielsweise wird 1,6-Hexandiol mit Adipinsäure und der entstandene Polyester dann mit Dicyclohexylmethan-4,4'-bis-diisocyanat im Molverhältnis 2 : 1 (Diisocyanat/Polyester) umgesetzt. Das Reaktionsprodukt wird mit 2-Hydroxyethylacrylat im Molverhältnis 2 : 1 umgesetzt, wobei ein polymerisierbares Oligomeres erhalten wird.

Weitere geeignete oligomere Diole sind z. B. Polyether, die durch Umsetzung eines Diols mit einem Alkylenoxid erhalten werden, wobei das Molverhältnis von Diol zu Alkylenoxid größer als 1: 1 sein muß, damit ein Polymeres erhalten

wird; und Epoxide, die durch Umsetzung einer symmetrischen Diglycidylverbindung mit einem Diol erhalten werden, wobei das Molverhältnis von Diol zu Diglycidylverbindung größer als 1 : 1 sein muß, damit ein Polymeres mit endständigen Hydroxylgruppen erhalten wird.

Geeignete Polyester werden zum Beispiel aus Oxal-, Malon-, Bernstein-, Glutar-, Adipin-, Pimelin-, Kork-, Azelain- oder Sebacinsäure und Ethylen-, Diethylen-, Neopentyl-, Propylen- und Dipropylenglykol, 1,3-Butandiol, 1,4-Butandiol, 1,6-Hexandiol oder 2-Ethyl-1,6-hexandiol erhalten.

Geeignete Polyether werden zum Beispiel aus den obengenannten Diolen und Ethylenoxid, Propylenoxid oder Tetrahydrofuran hergestellt.

Geeignete Epoxide werden zum Beispiel aus den obengenannten Diolen und Diglycidylisophthalat, Diglycidylterephthalat, Diglycidylphthalat oder Bisphenol-A-diglycidylether hergestellt.

Als Diisocyanate können zum Beispiel Ethylendiisocyanat, Propylendiisocyanat, Tetramethylendiisocyanat, Dicyclohexylmethan-4,4-diisocyanat, Hexamethylendiisocyanat, 1-Methyl-cyclohexan-2,3-diisocyanat, 1-Methylcyclohexan-2,6-diisocyanat, Lysindiisocyanat, 1,2-Bis-(4-isocyanatocyclohexyl)-ethan und Isophorondiisocyanat eingesetzt werden.

Zu den als Endgruppen geeigneten Verbindungen gehören zum Beispiel Hydroxyethylacrylat und -methacrylat, Hydroxypropylacrylat und -methacrylat, 1,3-Butandiolacrylat und -methacrylat, 2,4-Butandiolacrylat, 1,4-Butandiolmethacrylat, Neopentylglykolacrylat und -methacrylat, Pentaerythrittriacrylat und -trimethacrylat, sowie die Monoacrylate und Monomethylacrylate von Polyethylenglykol, Polypropylenglykol und von Copolymeren von Ethylenglykol und Propylenglykol.

Im Rahmen der vorliegenden Erfindung werden bevorzugt die Oligomeren mit einem Molekulargewicht von etwa 1500 bis 4000, insbesondere von etwa 2000 bis 3500, eingesetzt. Ganz besonders bevorzugt werden Oligomere verwendet, deren Molekulargewicht etwa 3000 beträgt. Vorteilhafterweise liegt das Oligomere in fester oder halbfester Form vor, d. h., seine Viskosität bei 25°C ist größer als etwa 480 Pa·s. Der bevorzugte Anteil des strahlungspolymerisierbaren Gemischs an Oligomerem beträgt etwa 10 bis 35 Gew.-%, insbesondere etwa 15 bis 30 Gew.-%, und ganz besonders bevorzugt beträgt er etwa 15 bis 25 Gew.-%, jeweils bezogen auf den Gesamtfeststoffgehalt.

Erfindungsgemäß ist weder eine Sauerstoffsperrschicht nötig, noch muß das Verfahren in einer Schutzgasatmosphäre aus Stickstoff durchgeführt werden. Dadurch ergeben sich die Vorteile, daß 1.) das lästige Auftragen einer zweiten Schicht entfällt, 2.) der Brechungsindex und die Löslichkeit der Sauerstoffsperrschicht nicht mehr berücksichtigt werden müssen, 3.) es nicht mehr zu einer Beeinträchtigung der Farbannahme durch die Bildstellen aufgrund von nicht entfernten Resten der Sauerstoffsperrschicht kommt, und 4.) keine zu hohe Bilddichte infolge der Sperrschicht mehr befürchtet werden muß.

Außerdem kann das durch Strahlung polymerisierbare erfindungsgemäße Gemisch noch andere Bestandteile, wie stabilisierende Säuren, Belichtungsindikatoren, Weichmacher, Photoaktivatoren und Farbmittel enthalten.

Geeignete stabilisierende Säuren sind zum Beispiel Phosphor-, Citronen-, Benzoe-, m-Nitrobenzoe-4-(p-Anilinophenylazo)-benzolsulfon-, 4,4'-Dinitro-2,2'-stilbendisulfon-, Itacon-, Wein- und p-Toluolsulfonsäure, sowie deren Gemische. Phosphorsäure wird als stabilisierende Säure bevorzugt. Der Anteil der gegebenenfalls zugesetzten stabilisierenden Säure am durch Strahlung polymerisierbaren Gemisch beträgt vorzugsweise etwa 0,3 bis 2,0 %, insbesondere etwa 0,75 bis 1,5 %.

Zu den erfindungsgemäß geeigneten Belichtungsindikatoren zählen u. a. 4-Phenylazodiphenylamin, Eosin, Azobenzol, Calcozine, Fuchsin-Farbstoffe, Kristallviolett und Methylenblau. 4-Phenylazodiphenylamin wird bevorzugt. Der Anteil des gegebenenfalls zugesetzten Belichtungsindikators am Gemisch beträgt vorzugsweise etwa 0,001 bis 0,0035 Gew.-%, insbesondere etwa 0,002 bis 0,030 Gew.-%, und ganz besonders bevorzugt etwa 0,005 bis 0,02 Gew.-%.

Der im Gemisch gegebenenfalls enthaltene Photoaktivator sollte eine Aminoverbindung sein, durch deren synergistisches Zusammenwirken mit dem radikalischen Photoinitiator die Radikallebensdauer des Photoinitiators, die normalerweise bei etwa $10^{-9}$ bis $10^{-15}$ Sekunden liegt, ausgedehnt wird. Beispiele geeigneter Photoaktivatoren sind 2-(m-Butoxy)-ethyl-4-dimethylaminobenzoat und acrylierte Amine. Ethyl-4-dimethylaminobenzoat wird bevorzugt. Der Anteil an Photoaktivator im erfindungsgemäßen Gemisch liegt bevorzugt bei 1,0 bis 4 Gew.-%.

Das erfindungsgemäße Gemisch kann ferner einen Weichmacher enthalten. Zu den geeigneten Weichmachern zählen zum Beispiel Tributylphthalat, Triarylphosphat und bevorzugt Dioctylphthalat. Der Anteil an Weichmacher im Gemisch liegt vorzugsweise bei etwa 0,5 bis 1,25 Gew.-%.

Zu den geeigneten Farbmitteln zählen u. a. Rhodamin, Calcozin, Viktoriablau und Methylviolett und Pigmente wie Anthrachinon und Phthalocyanin. Im allgemeinen liegt das Farbmittel in Form einer Pigmentdispersion vor, die ein oder mehrere Pigmente und/oder Farbstoffe enthält, die in einem geeigneten Lösemittel oder Lösemittelgemisch dispergiert wurden. Der Anteil des gegebenenfalls zugesetzten Farbmittels am erfindungsgemäßen Gemisch beträgt vorzugsweise etwa 1,5 bis 4,0

Gew.-%, insbesondere etwa 1,75 bis 3,0 Gew.-%, und ganz besonders bevorzugt etwa 2,0 bis 2,75 Gew.-%.

Für die Herstellung einer Beschichtungslösung für Flachdruckplatten kann das erfindungsgemäße Gemisch in einem Lösemittel oder Lösemittelgemisch dispergiert werden. Hierfür geeignete Lösemittel sind zum Beispiel Tetrahydrofuran, Propylenglykolmonomethylether, Butyrolacton, Ethylenglykolmonomethylether, andere Ethylenglykolether, Alkohole, wie Ethylalkohol und n-Propanol und Ketone, wie Methylethylketon, sowie Mischungen aus diesen Mitteln. Bevorzugt wird als Lösemittel eine Mischung aus Tetrahydrofuran, Propylenglykolmonomethylether und Butyrolacton verwendet.

Zu den Trägermaterialien, die für die Beschichtung mit dem erfindungsgemäßen Gemisch zur Herstellung von Flachdruckplatten geeignet sind, zählen transparente Folien, z. B. aus Polyester; Aluminium und seine Legierungen, andere Metalle, Silizium und ähnliche bekannte Stoffe.

Zur Herstellung lichtempfindlicher Materialien, z. B. von Flachdruckplatten, wird ein Schichtträger auf Basis von Aluminium zunächst vorzugsweise in bekannter Weise, z. B. durch Drahtbürsten, Naßschleifen oder auf elektrochemischem Weg, z. B. in einem Salzsäureelektrolyten, aufgerauht. Die aufgerauhte Platte wird danach vorzugsweise auf bekannte Weise anodisch oxidiert, z. B. in Schwefel- oder Phosphorsäure. Die aufgerauhte und anodisch oxidierte Oberfläche kann anschließend noch einer hydrophilierenden Nachbehandlung unterworfen werden, z. B. mit Polyvinylphosphonsäure. Die solchermaßen vorbereitete Platte wird mit dem erfindungsgemäßen Gemisch beschichtet. Das Schichtgewicht beträgt vorzugsweise etwa 0,6 bis 2,5 $g/m^2$, insbesondere etwa 0,8 bis 2,0 $g/m^2$, und ganz besonders bevorzugt etwa 1,2 bis 1,5 $g/m^2$; es ist jedoch im Rahmen der vorliegenden Erfindung nicht von entscheidender Bedeutung.

Die so hergestellte Druckplatte wird bevorzugt durch eine negative Testvorlage mittels aktinischer Strahlung so belichtet, daß nach dem Entwickeln auf einem Staufferkeil mit 21 Stufen die Stufe 6 voll gedeckt ist. Die belichtete Platte wird mit einem geeigneten Entwickler entwickelt, z. B. mit einem Entwickler auf der Basis organischer Lösemittel. Bevorzugt wird ein Entwickler verwendet, der 2-Propoxyethanol, ein nichtionisches Netzmittel und ein anorganisches Salz enthält. Entwickler dieser Art sind beispielsweise in den US-A-4 308 340 und 4 381 340 beschrieben. Die entwickelte Platte wird üblicherweise noch mit einem Konservierungsmittel behandelt, das ein hydrophiles Polymeres, z. B. in kaltem Wasser lösliches Dextrin und/oder Polyvinylpyrrolidon, ein nichtionisches Netzmittel, ein Feuchthaltemittel, ein anorganisches Salz oder Wasser enthalten kann, wie aus der US-A-4 213 887 hervorgeht.

Es ist bekannt, daß die mit einer so hergestellten Platte erzielbare Druckauflage durch eine Einbrennbehandlung der belichteten und entwickelten Druckplatte noch gesteigert werden kann. Bei einer fachgerechten Einbrennbehandlung wird die Druckplatte zunächst mit einer Lösung behandelt, durch die eine Hydrophilieeinbuße der Bildhintergrundstellen beim Einbrennen verhindert wird. Eine hierfür geeignete Lösung wird beispielsweise in der US-A-4 355 096 beschrieben. Nach dieser vorbereitenden Behandlung wird die Platte bei einer Temperatur zwischen 180° C und der Verformungstemperatur des Trägers, bevorzugt bei etwa 240° C, wärmebehandelt. Die Einbrenndauer ist umgekehrt proportional zur Temperatur und schwankt zwischen etwa 2 und 15 Minuten. Bei 240° C beträgt sie etwa 7 Minuten.

Die Erfindung wird anhand der folgenden Beispiele näher erläutert. Keine der nach den Beispielen 1 bis 5 hergestellten Platten ist mit einer Sauerstoffsperrschicht versehen oder in einer Schutzgasatmosphäre aus Stickstoff verarbeitet worden.

**Beispiel 1**

Eine 20 x 65 cm große Platte aus einer für Druckzwecke geeigneten Aluminiumlegierung des Typs 1100 wird mit einer wäßrig-alkalischen Entfettungslösung entfettet und in einem Medium aus Salpetersäure und Aluminiumnitrat mit Wechselstrom von 900 Coulomb elektrochemisch aufgerauht. Die aufgerauhte Platte wird gut abgespült und in einem Schwefelsäurebad anodisch oxydiert. Die Stromstärke und Spannung werden so gewählt, daß eine Oxidschicht von 2,8 $g/m^2$ erhalten wird. Danach wird die Platte nochmals abgespült und durch Tauchen in eine Polyvinylphosphonsäurelösung hydrophiliert. Nach einem letzten Spülgang wird die Platte getrocknet und anschließend mit einer Lösung der folgenden Zusammensetzung schleuderbeschichtet:

| | |
|---|---|
| 4,54 Gew.-% | eines Terpolymeren aus Vinylacetat-, Vinylalkohol- und Vinylformaleinheiten (Handelsprodukt Formvar 12/85), |
| 2,01 " | Dipentaerythritpentaacrylat, |
| 2,01 " | des unten angegebenen polymerisierbaren Urethanoligomeren, |
| 1,22 " | des Polykondensationsprodukts aus 3-Methoxy-diphenylamin-4-diazoniumsulfat und 4,4'-Bis-methoxymethyl-diphenylether, ausgefällt als Mesitylensulfonat und |

| | |
|---|---|
| 0,32 " | 2-(4-Styryl-phenyl)-4,6-bis-trichlormethyl-triazin in |
| 89,90 " | Ethylenglykolmonomethylether. |

Das polymerisierbare Urethanoligomere wird hergestellt durch Umsetzen eines Polyesterdiols aus 1,6-Hexandiol und Adipinsäure mit Dicyclohexylmethan-4,4'-diisocyanat im Molverhältnis 1 : 2 und weiteres Umsetzen des erhaltenen Diisocyanats mit 2 mol Hydroxyethylacrylat.

Die beschichtete und getrocknete Platte wird mittels aktinischer Strahlung durch eine negative Testvorlage so belichtet, daß Stufe 7 eines 21-Stufen-Staufferteils voll gedeckt ist. Die Platte wird mit einem Gemisch aus

| | |
|---|---|
| 14,85 Gew.-% | 2-Propoxy-ethanol, |
| 11,15 " | n-Propanol, |
| 8,00 " | $MgSO_4 \times 7 H_2O$, |
| 1,50 " | $NaH_2PO_4$ (wasserfrei), |
| 1,50 " | Polyvinylpyrrolidon (Molekulargewicht 10.000), |
| 0,75 " | Nonylphenolpolyoxyethylenether (40 mol Ethylenoxid) als 70-%-ige wäßrige Lösung, |
| 1,00 " | Polyethylenglykol 200 und |
| 61,25 " | Wasser |

entwickelt und mit einem Gemisch aus

| | |
|---|---|
| 5,52 Gew.-% | Dextrin (hydrolysiertes Tapiokadextrin), |
| 1,61 " | Natriumoctylsulfat, |
| 1,00 " | Isooctylphenolpolyoxyethylenether (4,5 mol Ethylenoxid), |
| 0,05 " | 1,4-Dimethyl-6-acetoxy-dioxan, |
| 2,37 " | $H_3PO_4$ und |
| 89,45 " | Wasser |

konserviert. Von der fertigen Druckplatte wird auf einer Solna-Bogenoffsetmaschine, die mit einem Dahlgren-Feuchtwerk ausgestattet ist, mit stark abreibender Druckfarbe und bei großer Belastung in der Maschine so lange gedruckt, bis die Platte unbrauchbar wird. Es werden 595.000 gute Drucke erhalten.

**Beispiel 2 (Vergleich)**

Eine Flachdruckplatte wird nach den Angaben in Beispiel 1 hergestellt und verarbeitet, das polymerisierbare Urethanoligomere wird jedoch weggelassen. Die so hergestellte Platte liefert lediglich 315.000 gute Drucke.

**Beispiel 3 (Vergleich)**

Eine Flachdruckplatte wird nach den Angaben in Beispiel 1 hergestellt und verarbeitet, das Dipentaerythritpentaacrylat wird jedoch weggelassen. Die so hergestellte Platte liefert lediglich 340.000 gute Drucke.

**Beispiel 4 (Vergleich)**

Eine Flachdruckplatte wird nach den Angaben in Beispiel 1 hergestellt und verarbeitet, doch wird die Diazoverbindung weggelassen. Die so hergestellte Platte liefert lediglich 220.000 gute Drucke.

**Beispiel 5 (Vergleich)**

Eine Flachdruckplatte wird nach den Angaben in Beispiel 1 hergestellt und verarbeitet, doch wird das 2-(4-Styryl-phenyl)-4,6-bis-(trichlormethyl)-triazin weggelassen. Die so hergestellte Platte liefert lediglich 335.000 gute Drucke.

Es ist ersichtlich, daß mit erfindungsgemäß hergestellten Druckplatten (nach Beispiel 1) wesentlich höhere Druckauflagen erzielt werden.

**Patentansprüche**

1. Lichtempfindliches Gemisch, das als wesentliche Bestandteile

a) ein polymeres Bindemittel,
b) ein Diazoniumsalz-Polykondensationsprodukt,
c1) einen radikalisch polymerisierbaren niedermolekularen Acryl- oder Methacrylsäureester mit 3 bis 6 ungesättigten Gruppen,
c2) einen radikalisch polymerisierbaren, Urethangruppen enthaltenden oligomeren Acryl- oder Methacrylsäureester und
d) einen Initiator für die Photopolymerisation

enthält, dadurch gekennzeichnet, daß der oligomere Acryl- oder Methacrylsäureester (c2) durch Umsetzen eines im wesentlichen linearen oligomeren Diols mit 2 mol eines Diisocyanats und weiteres Umsetzen des erhaltenen oligomeren Diisocyanats mit 2 mol eines Hydroxyalkylesters der Acryl- oder Methacrylsäure erhalten worden ist.

2. Lichtempfindliches Gemisch nach Anspruch 1, dadurch gekennzeichnet, daß das polymere Bindemittel ein Epoxyharz, Polyvinylester, Polyvinylacetal, Polyester, Polyamid, Polyether, Polyurethan, ein Polyacryl- oder -methacrylsäureester oder ein Mischpolymerisat eines der diesen Polymeren zugrundeliegenden Monomeren ist.

3. Lichtempfindliches Gemisch nach Anspruch 1, dadurch gekennzeichnet, daß der Initiator eine Verbindung mit mindestens einer photolytisch

spaltbaren Trichlormethylgruppe ist.

4. Lichtempfindliches Gemisch nach Anspruch 1, dadurch gekennzeichnet, daß das Diazoniumsalz-Polykondensationsprodukt wiederkehrende Einheiten $A-N_2X$ und B enthält, die durch zweibindige, von einer kondensationsfähigen Carbonylverbindung abgeleitete Zwischenglieder verbunden sind, wobei die Einheiten $A-N_2X$ sich aus Verbindungen der allgemeinen Formel

$$(R^1-R^3-)_pR^2-N_2X$$

ableiten und wobei

X das Anion der Diazoniumverbindung,
p eine ganze Zahl von 1 bis 3,
$R^1$ einen carbocyclischen oder heterocyclischen aromatischen Rest mit mindestens einer kondensationsfähigen Position,
$R^2$ eine Arylengruppe der Benzol- oder Naphthalinreihe,
$R^3$ eine Einfachbindung oder eine der Gruppen:

$-(CH_2)_q-NR^4-$

$-O-(CH_2)_r-NR^4-$,

$-S-(CH_2)_r-NR^4-$,

$-S-CH_2-CO-NR^4-$,

$-O-R^5-O-$,

$-O-$,

$-S-$ oder

$-CO-NR^4-$

bedeuten, worin

q eine Zahl von 0 bis 5,
r eine Zahl von 2 bis 5,
$R^4$ Wasserstoff, eine Alkylgruppe mit 1 bis 5 C-Atomen, eine Aralkylgruppe mit 7 bis 12 C-Atomen oder eine Arylgruppe mit 6 bis 12 C-Atomen, und
$R^5$ eine Arylengruppe mit 6 bis 12 C-Atomen ist, und
B den von Diazoniumgruppen freien Rest eines aromatischen Amins, Phenols, Thiophenols, Phenolethers, aromatischen Thioethers, aromatischen Kohlenwasserstoffs, einer aromatischen heterocyclischen Verbindung oder eines organischen Säureamids bedeuten.

5. Lichtempfindliches Gemisch nach Anspruch 1, dadurch gekennzeichnet, daß es den niedermolekularen Acryl- oder Methacrylsäureester in einer Menge von 10 bis 35 Gew.-%, bezogen auf die nichtflüchtigen Bestandteile des Gemischs enthält.

6. Lichtempfindliches Gemisch nach Anspruch 1, dadurch gekennzeichnet, daß es das Urethangruppen enthaltende Oligomere in einer Menge von 13 bis 35 Gew.-%, bezogen auf die nichtflüchtigen Bestandteile des Gemischs enthält.

7. Lichtempfindliches Material mit einem Schichtträger und einer darauf aufgebrachten lichtempfindlichen Schicht, dadurch gekennzeichnet, daß die lichtempfindliche Schicht aus einem lichtempfindlichen Gemisch gemäß Anspruch 1 besteht.

## Claims

1. Light-sensitive mixture which contains, as essential constituents,

a) a polymeric binder,
b) a diazonium salt polycondensation product,
c1) a radical-polymerisable low-molecular acrylic or methacrylic acid ester containing 3 to 6 unsaturated groups,
c2) a radical-polymerisable oligomeric acrylic or methacrylic acid ester containing urethane groups and
d) an initiator for the photopolymerisation,

characterized in that the oligomeric acrylic or methacrylic acid ester (c2) has been obtained by reacting an essentially linear oligomeric diol with 2 mol of a diisocyanate and by further reacting the oligomeric diisocyanate obtained with 2 mol of a hydroxyalkyl ester of the acrylic or methacrylic acid.

2. A light-sensitive mixture according to Claim 1, characterized in that the polymeric binder is an epoxy resin, polyvinyl ester, polyvinyl acetal, polyester, polyamide, polyether, polyurethane, a polyacrylic or polymethacrylic acid ester or a copolymer of a monomer forming the basis of said polymers.

3. Light-sensitive mixture according to Claim 1, characterized in that the initiator is a compound containing at least one photolytically cleavable trichloromethyl group.

4. Light-sensitive mixture according to Claim 1, characterized in that the diazonium salt polycondensation product contains recurring $A-N_2X$ and B units which are linked by divalent connecting members derived from a condensable carbonyl compound, the $A-N_2X$ units being derived from compounds of the general formula

$$(R^1-R^3-)_pR^2-N_2X$$

and where

X denotes the anion of the diazonium compound,
p denotes an integer from 1 to 3,
$R^1$ denotes a carbocyclic or heterocyclic aromatic radical containing at least one condensable position,
$R^2$ denotes an arylene group of the benzene or naphthalene series,
$R^3$ denotes a single bond or one of the groups:

$-(CH_2)_q-NR^4-$

-O-$(CH_2)_r$-$NR^4$-,

-S-$(CH_2)_r$-$NR^4$-,

-S-$CH_2$-CO-$NR^4$-,

-O-$R^5$-O-,

-O-,

-S- or

-CO-$NR^4$-

wherein

q is a number from 0 to 5,

r is a number from 2 to 5,

$R^4$ is hydrogen, an alkyl group containing 1 to 5 C atoms, an aralkyl group containing 7 to 12 C atoms or an aryl group containing 6 to 12 C atoms, and

$R^5$ is an arylene group containing 6 to 12 C atoms, and

B denotes the radical, free of diazonium groups, of an aromatic amine, pnenol, thiophenol, phenol ether, aromatic thioether, aromatic hydrocarbon, an aromatic heterocyclic compound or an organic acid amide.

5. Light-sensitive mixture according to Claim 1, characterized in that it contains the low-molecular acrylic or methacrylic acid ester in a quantity of 10 to 35 % by weight relative to the non-volatile constituents of the mixture.

6. Light-sensitive mixture according to Claim 1, characterized in that it contains the oligomer containing urethane groups in a quantity of 10 to 35 % by weight relative to the non-volatile constituents of the mixture.

7. Light-sensitive material with a film base and a light-sensitive film deposited thereon, characterized in that the light-sensitive film is composed of a light-sensitive mixture according to Claim 1.

**Revendications**

1. Mélange photosensible, qui contient comme constituants essentiels,

a) un liant polymère,

b) un produit de polycondensation d'un sel de diazonium,

c1) un ester acrylique ou méthacrylique de faible masse moléculaire, ayant 3 à 6 groupes insaturés, polymérisable par voie radicalaire,

c2) un ester acrylique où méthacrylique oligomère contenant des groupes uréthane, polymérisable par voie radicalaire et

d) un initiateur pour la photopolymérisation,

caractérisé en ce que l'ester acrylique ou méthacrylique monomère (c2) a été obtenu par réaction d'un diol oligomère essentiellement linéaire avec deux moles d'un diisocyanate, puis réaction du diisocyanate oligomère obtenu avec deux moles d'un ester hydroxyalkylique des acides acrylique ou méthacrylique.

2. Mélange photosensible suivant la revendication 1, caractérisé en ce que le liant polymère est une résine époxyde, un ester polyvinylique, un acétal polyvinylique, un polyester, un polyamide, un polyéther, un polyuréthanne, un ester polyacrylique ou polyméthacrylique ou un copolymère d'un des monomères qui est à la base de ces polymères.

3. Mélange photosensible suivant la revendication 1, caractérisé en ce que l'initiateur est un composé ayant au moins un groupe trichlorométhyle éliminable photolytiquement.

4. Mélange photosensible suivant la revendication 1, caractérisé en ce que le produit de polycondensation de sel de diazonium contient des motifs A-$N_2X$ et B qui sont liés par des éléments intermédiaires à deux liaisons, obtenus à partir d'un composé carbonylé condensable, les motifs A-$N_2X$ dérivant de composés répondant à la formule générale

$(R^1\text{-}R^3\text{-})_pR^2\text{-}N_2X$

dans laquelle

X est l'anion d'un composé diazonium,

p est un nombre entier de 1 à 3,

$R^1$ est un radical aromatique carbocyclique ou hétérocyclique ayant au moins une position condensable,

$R^2$ est un groupe arylène de la série du benzène ou du naphtalène,

$R^3$ est une liaison simple ou un des groupes:

-$(CH_2)_q$-$NR^4$-

-O-$(CH_2)_r$-$NR^4$-,

-S-$(CH_2)_r$-$NR^4$-,

-S-$CH_2$-CO-$NR^4$-,

-O-$R^5$-O-,

-O-,

-S- ou

-CO-$NR^4$-

dans lesquels

q est un nombre de 0 à 5,

r est un nombre de 2 à 5,

$R^4$ est un atome d'hydrogène, un groupe alkyle en $C_1$-$C_5$, un groupe aralkyle en $C_7$-$C_{12}$ ou un groupe aryle en $C_6$-$C_{12}$, et

$R^5$ est un groupe arylène en $C_6$-$C_{12}$, et

B désigne le radical exempt de groupes diazonium d'une amine aromatique, d'un phénol, d'un thiophénol, d'un éther phénolique, d'un thioéther aromatique, d'un hydrocarbure aromatique, d'un composé

hétérocyclique aromatique ou d'un amide organique.

5. Mélange photosensible suivant la revendication 1, caractérisé en ce qu'il contient l'ester acrylique ou méthacrylique de faible masse moléculaire dans une quantité de 10 à 35 % en poids par rapport aux constituants non-volatils du mélange.

6. Mélange photosensible suivant la revendication 1, caractérisé en ce qu'il contient l'oligomère contenant des groupes uréthane dans une proportion de 10 à 35 % en poids par rapport aux constituants non-volatils du mélange.

7. Matériau photosensible constitué d'un support de couche et d'une couche photosensible appliquée sur celui-ci, caractérisé en ce que la couche photosensible se compose d'un mélange photosensible suivant la revendication 1.